# FASCICULE DE BREVET EUROPEEN

(11) **EP 2 992 608 B1**
(45) Date de publication et mention de la délivrance du brevet: **07.06.2017**
(21) Numéro de dépôt: 14723014.8
(22) Date de dépôt: 23.04.2014
(51) Int. Cl.: H01L 41/08, H01L 41/04, H01L 41/18, H03L 1/02

(54) **PROCÉDÉ DE COMMANDE D'UN DISPOSITIF PIEZOÉLECTRIQUE À ELEMENT PIEZOÉLECTRIQUE RAPPORTÉ SUR UN SUPPORT**
VERFAHREN ZUR STEUERUNG EINER PIEZOELEKTRISCHEN VORRICHTUNG MIT EINEM AUF EINEM SUBSTRAT MONTIERTEN PIEZOELEKTRISCHEN ELEMENT
METHOD FOR CONTROLLING A PIEZOELECTRIC DEVICE HAVING A PIEZOELECTRIC ELEMENT MOUNTED ON A SUBSTRATE

(30) Priorité: 30.04.2013 FR 1354008
(43) Date de publication de la demande: 09.03.2016
(73) Titulaire: Safran Electronics & Defense, 92100 Boulogne-Billancourt (FR)
(72) Inventeur: ONFROY, Philippe, 92100 Boulogne Billancourt (FR)
(74) Mandataire: Lavialle, Bruno François Stéphane
(86) Numéro de dépôt international: PCT/EP2014/058282
(87) Numéro de publication internationale: WO 2014/177443

(56) Documents cités:
- US-A1- 2003 184 399
- US-A1- 2005 093 638
- US-A1- 2005 099 239
- US-A1- 2008 007 363
- US-A1- 2012 013 410

## Description

La présente invention concerne un procédé de commande d'un dispositif piézoélectrique à élément piézoélectrique. Un tel dispositif est par exemple un actionneur ou un capteur tel qu'un capteur inertiel vibrant comme un accéléromètre ou un gyroscope.

Il est connu de tel dispositif dans lesquels l'élément piézoélectrique est brasé ou collé sur un support en un matériau différent de celui de l'élément piézoélectrique. Lorsqu'un tel dispositif est soumis à des variations de températures les dimensions du support et de l'élément vibrants vont évoluer différemment en fonction des coefficients de dilatation thermique respectifs desdits matériaux. Il en résulte des dilatations différentielles qui engendrent des contraintes qui risquent de fausser l'amplitude des déplacements commandés dans le cas par exemple d'un actionneur et les mesures fournies par le dispositif lorsque celui-ci est un capteur. Ces contraintes sont d'autant plus importantes que les variations de températures sont importantes (il est usuel de rencontrer des températures variant entre -40°C et +90°C par exemple).

Ces dilatations différentielles produisent également des contraintes susceptibles d'altérer la couche de liant reliant l'élément piézoélectrique au support.

Le document US 2005/093638 montre un oscillateur à un élément piézoélectrique (DCXO) qui est contrôlé en fonction de la température ambiante.

Un but de l'invention est de remédier aux inconvénients précités.

A cet effet, on prévoit, selon l'invention un procédé de commande d'un dispositif piézoélectrique comportant un élément piézoélectrique fixé sur un support, le support et l'élément piézoélectrique étant dans des matériaux ayant des coefficients de dilatation thermiques différents. Le procédé comprend l'étape de soumettre l'élément piézoélectrique à une tension électrique déterminée pour entraîner une déformation de consigne de l'élément piézoélectrique et la tension électrique déterminée comprend une part de compensation déterminée en fonction d'une température ambiante pour annuler une contrainte engendrée sur l'élément piézoélectrique du fait d'une dilatation thermique différentielle entre l'élément piézoélectrique et le support.

Ainsi, la part de compensation de la tension de commande entraîne une déformation de l'élément piézoélectrique de manière à annuler la dilatation différentielle : par exemple, si le support subit, sous l'effet de la température, un allongement plus important que l'élément piézoélectrique, la part de compensation est déterminée pour provoquer un allongement supplémentaire de l'élément piézoélectrique de telle manière que le support et l'élément piézoélectrique aient des allongements identiques. Ceci présente en outre l'avantage d'offrir un plus grand nombre de possibilité dans le choix du matériau du support, le coefficient de dilatation thermique du matériau pouvant être négligé dans les critères de choix.

L'invention a également pour objet un dispositif piézoélectrique pour la mise en oeuvre de ce procédé.

D'autres caractéristiques et avantages de l'invention ressortiront à la lecture de la description qui suit d'un mode de réalisation particulier non limitatif de l'invention.

Il sera fait référence aux dessins annexés, parmi lesquels :
- la figure 1 est une vue schématique d'un dispositif selon l'invention ;
- la figure 2 est un diagramme montrant la part de compensation U' de la tension de commande u en fonction de la température Θ ;
- la figure 3 est un diagramme montrant la tension de commande u en fonction du temps t, à une température Θ1 ;
- la figure 4 est un diagramme montrant la tension de commande u en fonction du temps t, à une température Θ2.

En référence aux figures, le dispositif selon l'invention comprend un élément piézoélectrique 1 fixé sur un support 2 par l'intermédiaire d'une couche de colle 3. L'élément piézoélectrique 1 et le support 2 sont réalisés dans des matériaux ayant des coefficients de dilatation différents. De manière connue en elle-même, l'élément piézoélectrique 1 est relié à une unité de commande 4 par un circuit d'excitation 5.

L'unité de commande 4 est agencée pour mettre en oeuvre le procédé de commande conforme à l'invention.

Le procédé comprend l'étape de soumettre l'élément piézoélectrique 1 à une tension électrique déterminée pour entraîner une déformation de consigne non continue de l'élément piézoélectrique.

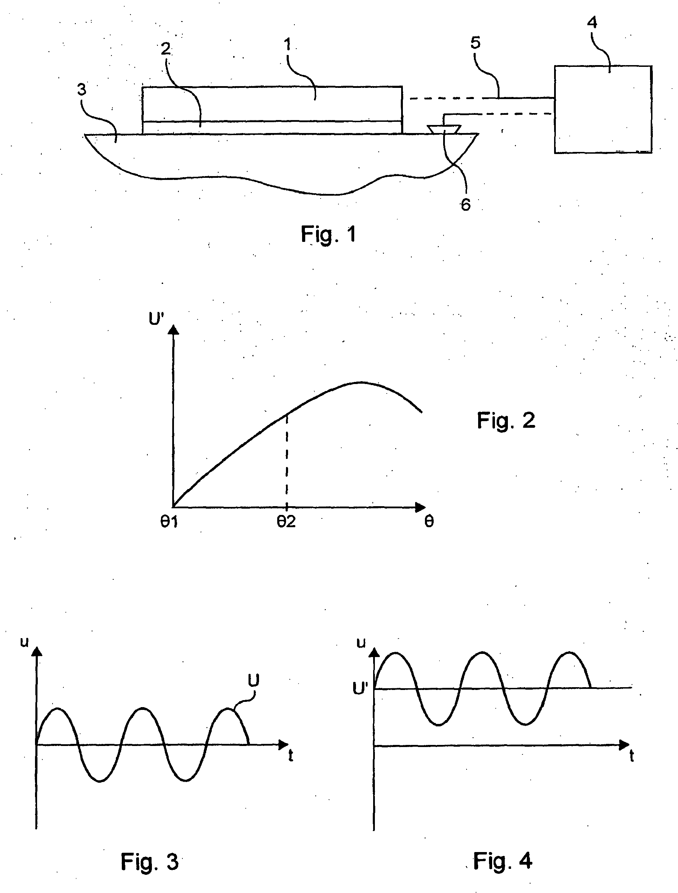

En référence plus particulièrement aux figures 2 à 4, la tension électrique déterminée u comprend une part de compensation U' déterminée en fonction d'une température ambiante Θ pour annuler une contrainte engendrée sur l'élément vibrant du fait d'une dilatation thermique différentielle entre l'élément vibrant 1 et le support 2. Par température ambiante, on entend une température au voisinage de l'élément piézoélectrique 1 et du support 2.

La figure 2 représente un exemple des valeurs de la part de compensation U' en fonction de la température ambiante Θ. Pour une température donnée Θ1 ou Θ2, la part de compensation U' est ici une valeur continue (voir les figures 3 et 4). La différence U=u-U' correspond à la tension nécessaire pour obtenir la déformation de consigne en l'absence de dilatation différentielle.

Dans l'exemple ici décrit, à la figure 3, la température Θ1 correspond à la température de fabrication du dispositif de sorte que l'assemblage élément piézoélectrique 1, support 2 et couche de colle 3 n'est le siège d'aucune dilatation différentielle : la part de compensation U' correspond donc à une valeur nulle.

En revanche, à la figure 4, la température Θ2 est supérieure à la température de fabrication du dispositif de sorte que l'assemblage élément piézoélectrique 1, support 2 et couche de colle 3 est le siège d'aucune dilatation différentielle : la part de compensation U' correspond donc à une valeur non nulle.

Pour la mise en oeuvre du procédé de l'invention, la température ambiante Θ est mesurée périodiquement et la part de compensation U' est déterminée périodiquement au moyen d'une table qui est mémorisée dans l'unité de commande 4 et qui met en relation des valeurs de la température ambiante Θ et des valeurs de la part de compensation U'. Cette table a par exemple été déterminée par des essais menés en usine ou par une simulation informatique à partir des températures ambiantes attendues dans l'application envisagée et des dilatations thermiques différentielles calculées à partir des coefficients de dilatation thermique des différents matériaux.

Pour la mesure de la température ambiante, le dispositif comprend avantageusement une sonde de température 6 fixée sur le support 2 au voisinage de l'élément piézoélectrique 1.

Bien entendu, l'invention n'est pas limitée aux modes de réalisation décrits mais englobe toute variante entrant dans le champ de l'invention telle que définie par les revendications.

En particulier, le procédé de l'invention peut être mis en oeuvre sans mesure de la température ambiante mais à partir d'autres données dont dépend la température ambiante. Par exemple, pour un dispositif embarqué dans un véhicule, la température ambiante peut être déduite ou estimée de la température extérieure au véhicule ou de données de géolocalisation du véhicule associées à des données d'horodatage. Lorsque le véhicule est un aéronef, la température ambiante peut être déduite ou estimée de l'altitude à laquelle l'aéronef évolue.

Plutôt que d'utiliser une table, la part de compensation de la tension de commande peut être calculée en temps réel à partir de la température ambiante dans l'application envisagée et des dilatations thermiques différentielles elles-mêmes calculées à partir des coefficients de dilatation thermique des différents matériaux.

Dans le mode de réalisation décrit, la température ambiante Θ est mesurée périodiquement et la part de compensation U' est déterminée périodiquement en fonction de la température ambiante Θ mesurée. En variante, il est possible, dans le cas où la température d'utilisation du dispositif est sensiblement constante tout en étant différente de la température à laquelle le dispositif est fabriqué, de déterminer avant utilisation la température ambiante attendue lors de l'utilisation et une part de compensation pour annuler les dilatations différentielles, cette part de compensation étant constante et appliquée systématiquement dès la mise en utilisation du dispositif.

## Revendications

1. Procédé de commande d'un dispositif piézoélectrique comportant un élément piézoélectrique (1) fixé sur un support (2), le support (2) et l'élément piézoélectrique (1) étant dans des matériaux ayant des coefficients de dilatation thermiques différents, le procédé comprenant l'étape de soumettre l'élément piézoélectrique (1) à une tension électrique (u) déterminée pour entraîner une déformation de consigne de l'élément piézoélectrique (1), où la tension électrique (u) déterminée comprend une part de compensation (U') déterminée en fonction d'une température ambiante (Θ) pour annuler une contrainte engendrée sur l'élément piézoélectrique (1) du fait d'une dilatation thermique différentielle entre l'élément piézoélectrique (1) et le support (2).

2. Procédé selon la revendication 1, dans lequel la température ambiante (Θ) est mesurée périodiquement et la part de compensation (U') est déterminée périodiquement.

3. Procédé selon la revendication 1, dans lequel la part de compensation (U') est déterminée au moyen d'une table mettant en relation des valeurs de température ambiante (Θ) et des valeurs de la part de compensation (U').

4. Dispositif piézoélectrique comportant un élément piézoélectrique (1) fixé sur un support (2), le support (2) et l'élément piézoélectrique (1) étant dans des matériaux ayant des coefficients de dilatation thermiques différents, le dispositif comportant une unité de commande (4) qui est reliée à un circuit d'excitation (4) de l'élément piézoélectrique (1) et qui est agencée pour mettre en oeuvre le procédé selon l'une quelconque des revendications précédentes.

## Patentansprüche

1. Verfahren zur Steuerung einer piezoelektrischen Vorrichtung, die ein piezoelektrisches Element (1) umfasst, das an einem Träger (2) befestigt ist, wobei der Träger (2) und das piezoelektrische Element (1) aus Materialien sind, die unterschiedliche Wärmeausdehnungskoeffizienten haben, wobei das Verfahren den Schritt des Anlegens einer vorgegebenen elektrischen Spannung (u) an das piezoelektrische Element (1) umfasst, um eine Sollverformung des piezoelektrischen Elements (1) zu verursachen, wobei die vorgegebene elektrische Spannung (u) einen Kompensationsanteil (U') umfasst, der in Abhängigkeit einer Umgebungstemperatur (Θ) bestimmt wird, um eine mechanische Spannung auszugleichen, die an dem piezoelektrischen Element (1) aufgrund einer unterschiedlichen Wärmeausdehnung zwischen dem piezoelektrischen Element (1) und dem Träger (2) erzeugt wird.

2. Verfahren nach Anspruch 1, bei dem die Umgebungstemperatur (Θ) periodisch gemessen und der Kompensationsanteil (U') periodisch bestimmt wird.

3. Verfahren nach Anspruch 1, bei dem der Kompensationsanteil (U') mittels einer Tabelle bestimmt wird, die Werte der Umgebungstemperatur (Θ) und Werte des Kompensationsanteils (U') in Beziehung setzt.

4. Piezoelektrische Vorrichtung, umfassend ein piezoelektrisches Element (1), das an einem Träger (2) befestigt ist, wobei der Träger (2) und das piezoelektrische Element (1) aus Materialien sind, die unterschiedliche Wärmeausdehnungskoeffizienten haben, wobei die Vorrichtung eine Steuereinheit (4) umfasst, die mit einem Erregerkreis (4) zur Erregung des piezoelektrischen Elements (1) verbunden ist und die so ausgebildet ist, dass sie das Verfahren nach einem der vorhergehenden Ansprüche durchführt.

## Claims

1. A method for controlling a piezoelectric device comprising a piezoelectric element (1) fixed on a substrate (2), with the substrate (2) and the piezoelectric element (1) being made of materials having different coefficients of thermal expansion, with the method comprising the step of subjecting the piezoelectric element (1) to a determined electric voltage (U) to cause a set deformation of the piezoelectric element (1), where the determined electric voltage (u) comprises a compensation portion (U') determined according to ambient temperature (Θ) to cancel a stress generated on the piezoelectric element (1) due to a differential thermal expansion between the piezoelectric element (1) and the substrate (2).

2. The method according to claim 1, wherein the ambient temperature (Θ) is periodically measured and the compensation portion (U') is periodically determined.

3. The method according to claim 1, wherein the compensation portion (U') is determined using a table relating ambient temperature values (Θ) with compensation portion (U') values.

4. A piezoelectric device comprising a piezoelectric element (1) fixed on a substrate (2), with the substrate (2) and the piezoelectric element (1) being made of materials having different coefficients of thermal expansion, with the device comprising a control unit (4) which is connected to an energizing circuit (4) of the piezoelectric element (1) and which is so arranged as to implement the method according to any one of the preceding claims.
